# EUROPEAN PATENT SPECIFICATION

(11) **EP 2 118 941 B1**
(45) Date of publication and mention of the grant of the patent: **13.08.2014**
(21) Application number: 08724435.6
(22) Date of filing: 08.01.2008
(51) Int. Cl.: H01L 39/24

(54) **SOLDERED SUPERCONDUCTOR WITH HARD INSULATION**
GELÖTETER SUPRALEITER MIT HARTISOLIERUNG
SUPRACONDUCTEUR SOUDÉ AVEC ISOLATION RIGIDE

(30) Priority: 09.01.2007 US 651443
(43) Date of publication of application: 18.11.2009
(73) Proprietor: Oxford Superconducting Technology, Carteret, NJ 07008-0429 (US)
(72) Inventor: HONG, Seungok, New Providence, NJ 07974 (US); MEINESZ, Maarten, Parlin, NJ 08859 (US); ZHANG, Youzhu, East Brunswick, NJ 08816 (US); PARRELL, Jeff, Roselle Park, NJ 07201 (US); FIELD Michael, Jersey City, NJ 07306 (US)
(74) Representative: Howard, Paul Nicholas
(86) International application number: PCT/US2008/000229
(87) International publication number: WO 2008/085955

(56) References cited:
- JP-A- H04 106 809
- JP-A- S60 250 834
- US-A- 4 278 310
- US-A- 4 480 007
- US-A- 4 506 109
- US-A- 4 980 964
- US-A1- 2004 226 163
- US-A1- 2004 226 163
- US-B1- 6 586 509
- US-B2- 6 932 874
- US-B2- 6 932 874

## Description

### FIELD OF INVENTION

This invention relates generally to the manufacture of superconductors, and more specifically, relates to a method enabling the addition of a hard insulation film to a multifilamentary superconductor that has been soldered to a large amount of copper, thus minimizing production cost and giving increased control of copper content. A hard insulation film gives the minimum insulation layer thickness, thus maximizing conductor volume for use in a electromagnetic coil.

### BACKGROUND OF INVENTION

Superconducting wire composites used in electromagnets, such as those used for magnetic resonance imaging (MRIs), consist of a multifilamentary superconductor, copper stabilizing matrix, and an outer electrical insulation layer. The superconducting alloy in the multifilamentary strand is usually niobium titanium. The electrical insulation layer on the superconductor wire is critical to its proper performance in most applications. This is particularly true in the construction of solenoid magnets, where multiple layers of wire are wound together under high winding tensions. Tum-to-tum or layer-to-layer electrical shorts seriously degrade performance, and must be prevented.

For large superconducting magnets, a high volume fraction of copper stabilizer is often needed for optimal magnet performance. In the superconducting wire manufacturing process, the most cost effective way to produce a conductor having a high copper content is to make a composite of multifilamentary superconductor containing a small volume fraction of copper matrix, and then join it with a large amount of additional copper at the final stage of manufacturing. The most common method to integrate the components is soldering. The majority of superconductor composite used for MRI is made by soldering a low copper content superconducting strand into the round groove of a relatively large volume generally rectangular shaped copper channel. This process has been referred to as "wire-in-channel". These conductors are usually insulated with glass or polymer braid, or tape. After winding the magnet, the entire wire assembly is infiltrated with an epoxy to bond the winding together and to prevent any wire movement during operation. It should be noted that while the composite has a generally rectangular cross-section (for maximum compaction in a magnet coil), the corners are rounded to allow evacuation of gasses and the potting of the coil. Other types of soldered conductors are also known in the prior art. JP H04 106809 discloses joining a stabilizing metal and an Nb-Ti alloy superconducting wire with a brazing filler metal whose melting point is of 320°C-620°C.

Another type of insulation, a much thinner (and therefore preferred) organic film insulation (or "varnish"), has been employed in situations where the insulation can be cured at an elevated temperature onto the wire. The modified polyvinyl acetal resin Formvar® is the most common type of organic film insulation used for this purpose. This curing temperature typically exceeds the melting point of traditional Sn-Pb solder alloy, which are standard alloys used because of their excellent soldering characteristics. Due to this curing temperature/melting temperature incompatibility, the employment of organic film insulation has so far excluded wire-in-channel composites, and required so-called "monolith" superconducting composites. Monoliths are singlepiece multifilamentary superconducting wires which are manufactured with all of the needed copper from start of manufacturing, and thus never need to be bonded with solder into a copper channel.

The drawbacks of these approaches are as follows:
1. Although the glass or polymer braid is a very effective insulation scheme, it also is relatively thick and therefore consumes a considerable fraction of the cross-section of an insulated superconducting composite and thus coil space. This results in a much larger, heavier, and less efficient system.
2. Although Formvar® and similar thin film insulations save considerable space in the cross-section of an insulated superconducting composite they required (in the prior art) the use of monolith superconducting composites which are not cost effective because a considerable volume of copper is co-processed with the superconductor starting at an early processing stage, which is an inefficient manufacturing process.

Formvar® had not been successfully applied to a soldered composite super -conductor used in MRI magnets, because of the low 181 °C melting point of the eutectic Pb-Sn solder alloy. A number of attempts had been made to modify the Formvar® formulations and application processes themselves, without success. During the application of Formvar®, the conductor is coated with liquid Formvar®, and then the coated composite passes through a heat treatment tower furnace at a temperature significantly higher than the solder melting temperature. This causes the Sn-Pb solder to melt, disrupting the composite bonding, and creates bubbles in the insulating film, preventing proper application and adherence of the insulation.

### SUMMARY OF INVENTION

The present invention overcomes the problems listed above by use of a high melting point solder to bond the superconductor strand to a solderable metallic component such as a copper channel, as defined in the method of claim 1. The solder must be able to withstand, without re-melting, the exposure to the elevated temperature and environment in the insulation processing tower. The temperature at which the solder melts is critical to the proper application of the insulating film. Through the use of a high temperature solder alloy, soldered conductor can be successfully coated with film insulation. While the temperature in the processing tower may be twice the melting point of even the high temperature solder, one can limit the transit time of the composite. This process results in the actual temperature of the composite being brought into the range of -200°C, i.e. in the range that would melt a eutectic Sn-Pb solder but not a high temperature solder, yet is still suitable for curing the Formvar® layer.

The superconducting composite of choice for soldering into the channel is typically Nb-Ti in a Cu matrix, although a Cu-Ni matrix may be chosen. Typically the strand is round in cross-section but a rectangular cross-section conductor may also be used. Typically the high copper fraction composite is made by bonding a shaped channel to the superconducting core, but a copper strip instead could be wrapped around the superconducting core.

The solder selection critically depends on the amount of intermetallic formation during the superconducting strand-to-copper channel solder bonding operation, and any subsequent thermal treatment the conductor may undergo. An interface layer thickness of 1-3 µm (microns) between the solder and copper composite superconductor is ideal for most solder operations to obtain the maximum solder bond strength. An intermetallic layer much thicker could result in a brittle interface.

Solder selection is also critical in that full and even filling of the groove in the channel is necessary to prevent eventual bubble formation in the insulation layer. This is controlled by the wetting and surface tension characteristics of the solder alloy, and the degree of superheat used in the soldering process.

Good thermo-mechanical fatigue properties are required to ensure that neither the varnish nor solder bond rupture during cycling of the device from room temperature to liquid helium temperature, or that the various films themselves do not undergo fatigue causing failure of the conductor or insulation. The coefficient of thermal expansion is important so that the composite does not undergo excessive strain on cooling down to liquid helium temperature (4.2K). It is not necessary to determine the actual coefficient of temperature expansion but only to cycle the coated conductor repeatedly from room temperature to liquid helium temperature and evaluate the adherence of the insulating film.

The success of this process lies in the higher melting point of the solder alloy such that the integrity of the solder bond is not compromised during the insulation film application process, that the solder fills the channel groove, and that the solder strongly bonds to the copper itself. Solder alloys containing Sn, Ag, Sb, and Cu with higher melting temperatures are all suitable for this application. This is even true for alloys with a relatively low liquidus but high solidus temperature. The alloy will not flow in the intermediate liquidus/solidus range due to the high viscosity. Generally solder having a high Pb content melts at higher temperature, but the use of Pb is not environmentally friendly, and its use is being restricted by legislation in many regions. An excellent wettability of solder to the copper base metal is very important since any trapped gas in voids can outgas during the Formvar® curing process and prohibit bonding of insulation to conductor. Tin rich solders tend to have excellent wettability. A few examples of suitable alloys are given in Table 1. It should be noted that any solder employed cannot have a melting point far above 300°C as this would degrade the superconducting properties of the niobium-titanium alloy in the wire. Also, any solder alloy under consideration should be evaluated for "tin pest", the transformation of the crystal structure of tin to the brittle diamond cubic structure (gray tin α, a semiconductor). This must be avoided, and has been known to occur in lead-free solders.

**Table 1: TIN-BASED SOLDER ALLOYS HAVING A HIGH TEMPERATURE MELTING RANGE**

| Nominal Composition, % by weight | | | | Melting Temperature Range |
|---|---|---|---|---|
| Sn | Ag | Cu | Sb | C° |
| 95 | | | 5 | 232°-240° |
| 98 | 2 | | | 221 °-226° |
| 99.3 | | 0.7 | | 227° liquidus |
| 95.5 | 3.8 | 0.7 | | 220° liquidus |
| 95 | 4 | 1 | | 220° |
| 93.6 | 4.7 | 1.7 | | 244° |
| 65 | 25 | 10 | | 233° |
| 95.5 | 0.5 | 4 | | 217°-350° |

Surface roughness of the solder-coated superconducting composite is important only when the adherence of the film is marginal. Providing a rough surface allows the insulating varnish to mechanically grip the surface and provide a better bond. The surface modification can be done by any of the conventional techniques such as abrasion with sandpaper, grit blasting, or embossing. When grit blasting is applied, the composition of the grit and the angle that it is applied is important in providing the best bonding surface, and this depends on the particular varnish and solder combination. The embossing can be done prior to, during or after the soldering operation. Surface roughness can also be obtained by the selection of the dies used for shaping after the soldering and via the quenching operations on the soldering line. It is also possible to remove by electroplating off the surface solder (but not the solder bonding the core to the channel) to have a cleaner surface for insulation application.

The polymer hard insulation coating can be an epoxy, enamel or varnish type insulation with a curing temperature of over 300°C. The polymer can be applied by running the soldered strand through a tank of liquid insulation or by extruding the insulation with the strand. Examples of extrudable polymers include nylon, epoxy, PVC, polyethylene and floro-chloro-carbons.

### BRIEF DESCRIPTION OF DRAWINGS

In the drawings appended hereto:
FIGURE 1 is a simplified schematic cross-section of a typical multifilamentary superconductor configuration of Nb-Ti rods and a round copper matrix;
FIGURE 2 is a simplified schematic cross-section of a solder-coated wire in channel composite consisting of superconducting strand, copper channel, and solder bonding layer;
FIGURE 3 is a simplified schematic cross-section of a wire-in-channel composite consisting of superconducting strand, copper channel, solder bonding layer, and outer varnish or enamel insulating layer; and
FIGURES 4(a) and 4(b) are two cross sectional photomicrographs, showing in 4(a) a product produced by the method of the invention, and in 4(b) a product produced by prior art methodology.

### DESCRIPTION OF THE PREFERRED EMBODIMENT

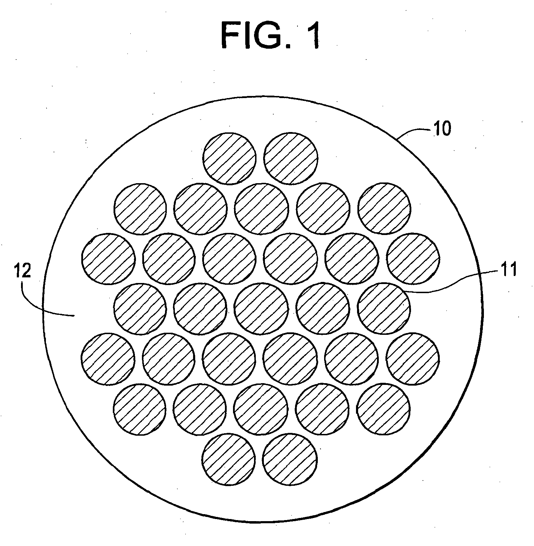

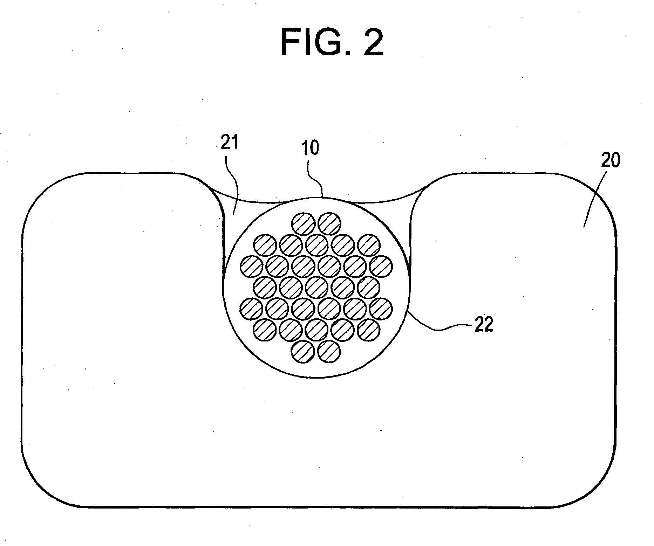

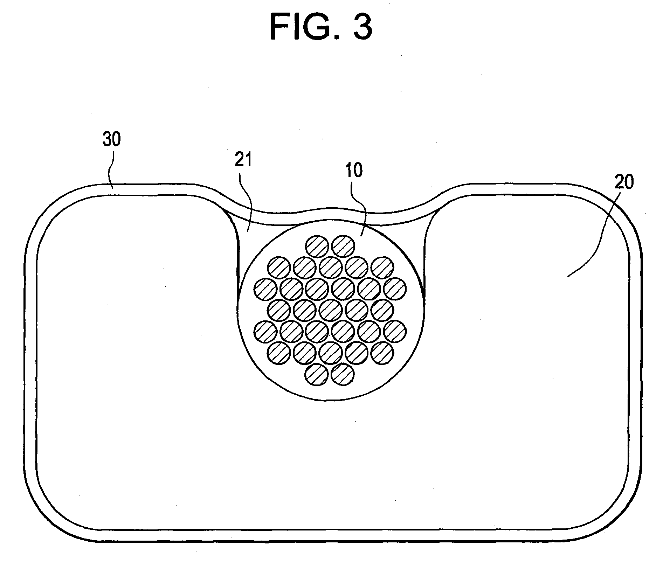

A multifilamentary superconducting composite is created as shown by the example illustrated in figure 1, where multiple Nb-Ti alloy rods **11** are stacked into drilled copper billets **12,** lids and cones are welded to the billet ends to facilitate extrusion, and the billets are extruded to form the multifilamentary rod 10. This multifilamentary rod is reduced from typically 76mm (3") diameter to wire about 500 µm (0.02") diameter by rod and wiredrawing techniques familiar to those skilled in the art. Then, as shown in Figure 2, this multifilamentary superconducting wire 10 is soldered into a copper channel 20 with a high temperature solder 21, with examples of valid selections of solder being shown in (but not limited to) those in Table 1. Solder application can be effected by passing the assembly of rod 10 and channel 20 through a solder pot as is known in the art, or other known techniques can be used to apply the solder. It is necessary that the solder 21 evenly fills the channel groove 22 to prevent bubble formation during the subsequent insulation process. This soldered multifilamentary composite is then run through a processing line consisting of a tank applying (but not limited to) Formvar® layers and a curing oven tower at elevated temperature, on the order of 400°C. The dwell time in the furnace is controlled in consideration of the tower temperature and the composition assembly so that this furnace temperature results in a wire temperature on the order of 200°C, too high for a conventional solder but below the melting temperature of the high temperature solders. Typically the processing line is set up so that a single section of wire experiences multiple passes through the Formvar® coating and drying process to build the Formvar® layer to an acceptable thickness. The end result is represented in the schematic cross-section shown in Figure 3, where the Formvar® layer 30 coats the superconducting multifilamentary wire 10, copper channel 20, and the high temperature solder 21.

### EXAMPLE

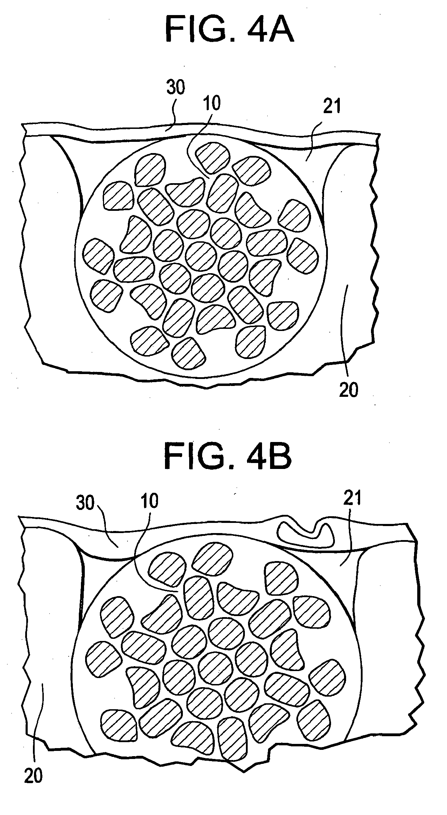

A solder alloy Sn-5wt%Sb having a melting temperature range of 232-240°C was used to solder a copper-matrix (copper alloy UNS 10100) superconductor wire consisting of 31 filaments of Nb-47wt%Ti into a copper channel at 260°C. This soldered composite was cleaned and then coated with Formvar® and passed through a tower furnace operating at 400°C. The wire temperature measured at the exit of the tower was 205°C. The coating and curing steps were repeated several times to build an acceptable layer of Formvar® on the composite surface. The resulting product had excellent properties. As is seen from an example cross-section in Figure 4a, there was no evidence of disbonding or bubbling of the solder, and the wire remained in the groove and flush with the channel surface. The composite had minimal degradation in yield strength after the heating from the insulation process, and the varnish insulation film has excellent adherence to the wire substrate. When a prior art low melting temperature Pb-based solder was used, evidence of the solder bubbling can be seen in Figure 4b, resulting in bubbling, distortion, and disruption of the insulation layer.

## Claims

1. A method for the fabrication of an insulated solder bonded multifilamentary superconducting wire composite, comprising the steps of:
(a) creating an uninsulated wire composite by using a high melting point solder comprising predominately Sn with one or more alloying metals selected from the group consisting of Sb, Ag, and Cu, and solder bonding a multifilamentary superconducting composite to a solderable metallic component;
(b) applying a polymer insulation film coating on top of the wire composite from step (a); and
(c) subjecting the assembly from step (b) to heating in a furnace at furnace temperatures and for a period sufficient to cure the said insulation but insufficient to melt the said solder.

2. A method in accordance with claim 1, wherein the melting point of the solder is above 200° C and less than 300° C.

3. A method in accordance with claim 2, wherein the high melting point solder is Sn 5 wt % Sb.

4. A method in accordance with claim 1, wherein the multifilamentary composite comprises Nb-Ti alloy filaments in a copper matrix, or Nb-Ti alloy filaments in a Cu-Ni alloy matrix.

5. A method in accordance with claim 1, wherein the multifilamentary superconducting composite has a round cross-section, or a generally rectangular cross-section.

6. A method in accordance with claim 5, wherein the multifilamentary superconducting composite has a round cross-section and wherein the soldered composite is made by wrapping Cu strip around a round wire.

7. A method in accordance with claim 5, wherein the multifilamentary superconducting composite has a round cross-section and wherein the soldered composite is made by the "wire in channel process" of soldering round wire into a round groove in a generally rectangular shaped channel.

8. A method in accordance with claim 7 wherein the solderable metallic channel is pure Cu, Cu alloy, or a Cu clad metal.

9. A method in accordance with claim 5, wherein the multifilamentary superconducting composite has a generally rectangular cross-section, and wherein the soldered composite is made by soldering rectangular (flat) wire to rectangular Cu, Cu alloy, or a Cu clad metal strip.

10. A method in accordance with claim 1 wherein the polymer coating is a Formvar® (modified polyvinyl acetal resin) varnish insulation.

11. A method in accordance with claim 1 wherein the polymer coating is selected from the group consisting of epoxy, enamel, nylon or varnish type insulations with a curing temperature of over 300° C.

12. A method in accordance with claim 1, where after application of the insulation, the entire composite is drawn and/or shaped into a desired configuration.

13. A method in accordance with claim 1 wherein the application of the polymer insulation is by extrusion.

14. A method in accordance with claim 13, wherein the polymer used is an extrudable one selected from the group consisting of nylon, epoxy, PVC, polyethylene and fluoro-chloro-carbon polymers.

15. A method in accordance with claim 1, wherein the surface solder, but not the solder bonding the wire to the channel, is removed prior to application of the insulation by electroplating off the solder.

16. A method in accordance with claim 1, wherein the surface solder is roughened by sandblasting, grit blasting, or embossing.

## Patentansprüche

1. Verfahren für die Herstellung eines supraleitenden isolierten lötgebondeten Mehrfaden-Drahtkomposits, umfassend die folgenden Schritte:
(a) Produzieren eines unisolierten Drahtkomposits durch Verwenden eines Lots mit hohem Schmelzpunkt, das überwiegend Sn mit einem oder mehreren legierenden Metallen umfasst, ausgewählt aus der Gruppe bestehend aus Sb, Ag und Cu, und Lötbonden eines supraleitenden Mehrfaden-Komposits an eine lötbare metallische Komponente;
(b) Aufbringen einer Polymerisolationsfilmbeschichtung auf das Drahtkomposit von Schritt (a) und
(c) Erhitzen der Baugruppe von Schritt (b) in einem Ofen bei Ofentemperaturen und für eine Periode, die ausreicht, die Isolation zu härten, aber nicht ausreicht, das Lot zu schmelzen.

2. Verfahren nach Anspruch 1, wobei der Schmelzpunkt des Lots über 200°C und unter 300°C liegt.

3. Verfahren nach Anspruch 2, wobei das Lot mit dem hohen Schmelzpunkt Sn 5 Gew.-% Sb ist.

4. Verfahren nach Anspruch 1, wobei das Mehrfaden-Komposit Nb-Ti-Legierungsfäden in einer Kupfermatrix oder Nb-Ti-Legierungsfäden in einer Cu-Ni-Legierungsmatrix umfasst.

5. Verfahren nach Anspruch 1, wobei das supraleitende Mehrfaden-Komposit einen runden Querschnitt oder einen allgemein rechteckigen Querschnitt aufweist.

6. Verfahren nach Anspruch 5, wobei das supraleitende Mehrfaden-Komposit einen runden Querschnitt aufweist und wobei das gelötete Komposit durch Wickeln eines Cu-Streifens um einen runden Draht herum hergestellt wird.

7. Verfahren nach Anspruch 5, wobei das supraleitende Mehrfaden-Komposit einen runden Querschnitt aufweist und wobei das gelötete Komposit durch den "Draht-in-Kanal-Prozess" des Lötens eines runden Drahts in eine runde Nut in einem allgemein rechteckig geformten Kanal hergestellt wird.

8. Verfahren nach Anspruch 7, wobei der lötbare metallische Kanal reines Cu, Cu-Legierung oder ein Cubeschichtetes Metall ist.

9. Verfahren nach Anspruch 5, wobei das supraleitende Mehrfaden-Komposit einen allgemein rechteckigen Querschnitt aufweist und wobei das gelötete Komposit durch Löten eines rechteckigen (flachen) Drahts an rechteckiges Cu, Cu-Legierung oder einen Cubeschichteten Metallstreifen hergestellt wird.

10. Verfahren nach Anspruch 1, wobei die Polymerbeschichtung eine Formvar®-(modifiziertes Polyvinylacetalharz)-Lackisolation ist.

11. Verfahren nach Anspruch 1, wobei die Polymerbeschichtung aus der Gruppe bestehend aus Isolationen vom Typ Epoxid, Decklack, Nylon oder Lack mit einer Härtetemperatur von über 300°C ausgewählt ist.

12. Verfahren nach Anspruch 1, wobei nach dem Aufbringen der Isolation das ganze Komposit in eine gewünschte Konfiguration gezogen und/oder geformt wird.

13. Verfahren nach Anspruch 1, wobei das Aufbringen der Polymerisolation durch Extrusion erfolgt.

14. Verfahren nach Anspruch 13, wobei das verwendete Polymer ein extrudierbares ist, ausgewählt aus der Gruppe bestehend aus Nylon, Epoxid, PVC, Polyethylen und Fluorchlorkohlenstoffpolymere.

15. Verfahren nach Anspruch 1, wobei das Oberflächenlot, aber nicht das den Draht an den Kanal bondende Lot, vor dem Aufbringen der Isolation durch Abgalvanisieren des Lots entfernt wird.

16. Verfahren nach Anspruch 1, wobei das Oberflächenlot durch Sandstrahlen, Strahlen mit körnigem Strahlmittel oder Prägen aufgeraut ist.

## Revendications

1. Procédé de fabrication d'un fil composite supraconducteur multifilament soudé par brasure isolé, comprenant les étapes consistant à :
(a) créer un fil composite non isolé en utilisant une brasure à point de fusion élevé comprenant principalement du Sn avec un ou plusieurs métaux d'alliage choisis dans le groupe constitué par Sb, Ag et Cu, et souder par brasure un composite supraconducteur multifilament à un composant métallique soudable ;
(b) appliquer un revêtement de film d'isolation polymère sur le fil composite de l'étape (a) ; et
(c) soumettre l'ensemble de l'étape (b) à un chauffage dans un four à des températures de four et sur une période suffisantes pour durcir ladite isolation, mais insuffisantes pour faire fondre ladite brasure.

2. Procédé selon la revendication 1, dans lequel le point de fusion de la brasure est supérieur à 200 °C et inférieur à 300 °C.

3. Procédé selon la revendication 2, dans lequel la brasure à point de fusion élevé est du Sn à 5 % de Sb.

4. Procédé selon la revendication 1, dans lequel le composite multifilament comprend des filaments d'alliage Nb-Ti dans une matrice de cuivre, ou des filaments d'alliage Nb-Ti dans une matrice d'alliage Cu-Ni.

5. Procédé selon la revendication 1, dans lequel le composite supraconducteur multifilament a une section transversale ronde, ou une section transversale généralement rectangulaire.

6. Procédé selon la revendication 5, dans lequel le composite supraconducteur multifilament a une section transversale ronde et dans lequel le composite soudé est fabriqué en enroulant une bande de Cu autour d'un fil rond.

7. Procédé selon la revendication 5, dans lequel le composite supraconducteur multifilament a une section transversale ronde et dans lequel le composite soudé est fabriqué par le « procédé du fil en canal » de soudage d'un fil rond dans un sillon rond dans un canal de forme généralement rectangulaire.

8. Procédé selon la revendication 7 dans lequel le canal métallique soudable est du Cu pur, un alliage de Cu, ou un métal plaqué de Cu.

9. Procédé selon la revendication 5, dans lequel le composite supraconducteur multifilament a une section transversale généralement rectangulaire, et dans lequel le composite soudé est fabriqué en soudant un fil rectangulaire (plat) à une bande rectangulaire de Cu, d'alliage de Cu, ou d'un métal plaqué de Cu.

10. Procédé selon la revendication 1 dans lequel le revêtement polymère est une isolation par vernis Formvar® (résine de polyvinylacétal modifiée).

11. Procédé selon la revendication 1 dans lequel le revêtement polymère est choisi dans le groupe constitué par les isolations de type époxyde, émail, nylon ou vernis avec une température de durcissement de plus de 300 °C.

12. Procédé selon la revendication 1, où après application de l'isolation, le composite entier est étiré et/ou façonné dans une configuration souhaitée.

13. Procédé selon la revendication 1 dans lequel l'application de l'isolation polymère se fait par extrusion.

14. Procédé selon la revendication 13, dans lequel le polymère utilisé est un polymère extrudable choisi dans le groupe constitué par le nylon, l'époxyde, le PVC, le polyéthylène et les polymères chlorofluorocarbonés.

15. Procédé selon la revendication 1, dans lequel la brasure de surface, mais pas la soudure par brasure du fil au canal, est retirée avant application de l'isolation par retrait électrolytique de la brasure.

16. Procédé selon la revendication 1, dans lequel la brasure de surface est rendue rugueuse par sablage, grenaillage, ou gaufrage.
